# EUROPEAN PATENT APPLICATION

(11) **EP 4 719 008 A1**
(43) Date of publication of application: **01.04.2026**
(21) Application number: 25197800.3
(22) Date of filing: 25.08.2025
(51) Int. Cl.: H10H 20/01, H10H 20/831, H10H 20/833, H10H 20/841, H10H 20/832

(54) **METHODS AND DEVICES FOR LIGHT EMITTING DEVICE WITH COMPOSITE CONTACT**

(30) Priority: 26.09.2024 US 202418897633
(71) Applicant: Lumileds Singapore Pte. Ltd., Singapore 768925 (SG)
(72) Inventor: Lopez-Julia, Antonio, 52068 Aachen (DE); Young, Erik, San Jose, 95131 (US); Pathak, Rajiv, San Jose, 95131 (US); Seow, Huifen, 768925 Singapore (SG); Cen, Zhanhong, 768925 Singapore (SG); Tjioe, Fidelia, 768925 Singapore (SG); Foo, Chee-Yin, 768925 Singapore (SG); Tan, Calvert Siew Joo, 768925 Singapore (SG); Kee, Yeh Yee, 768925 Singapore (SG); Sun, Zhiqiang, 768925 Singapore (SG)
(74) Representative: dompatent

(57) **Abstract**

A light emitting device with a composite contact prevents performance degradation caused during laser lift off. The composite contact includes a transparent and conductive layer absorbing the laser to prevent it from reaching the metal trench while serving as a current spreading layer, and includes one or more other layers such as a dielectric spacer preventing optical loss, and a thin contact layer providing better contact with the metal trench than the transparent conductive layer might by itself.

## Description

### FIELD OF THE INVENTION

The invention relates generally to light emitting devices, particularly methods and devices including light emitting devices with one or more composite contacts.

### BACKGROUND

Inorganic light emitting diodes (i-LEDs) have been widely used to create different types of displays, LED matrices and light engines including automotive adaptive headlights, augmented-, virtual-, mix-reality (AR/VR/MR) headsets, smart glasses and displays for mobile phones, smart watches, monitors and TVs. The individual LED pixels in these architectures could have an area of few square millimetres down to few square micrometres depending on the matrix or display size and its pixel per inch requirements. One common approach is to create a monolithic array of LED pixels on an EPI wafer and later transfer and hybridize these LED arrays to a backplane silicon chip to control individual pixels.

One type of such monolithic arrays requires metal (e.g., Al- or Ag-based) side-contacts. These contacts serve as the electrical cathode for each pixel and further provide reflective sidewalls in between the pixels to reduce light scattering and propagation in lateral directions. A metal grid forms a matrix of LED pixels. Aluminum side-contacts are typically extended deep into the bottom of the trench reaching the substrate's surface. Deep side contacts are used to ensure low contact resistance to the semiconductor, as well as to optically isolate each LED pixel.

During fabrication, the substrate (e.g., sapphire or silicon) should be removed so that the resulting emitter features high light extraction and low crosstalk. The standard approach to remove a substrate is by laser lift-off (LLO) wherein a laser beam (UV laser for sapphire) is used to detach the substrate from the epitaxial layers.
Problems with the aforementioned die architectures are multiple: First, side metal contacts are usually poor optical reflectors and represent a major limitation to high efficiency, particularly light extraction efficiency ExE. Second, since Al- or Ag-based cathodes are entrenched down to the substrate's surface, they may interact with the laser beam from the LLO process and create Al- or Ag-rich droplets or other Al-or Ag- containing by-products, which are generally absorptive and thus additionally contribute to decrease light output. Impaired sidewall contacts may also affect the electrical performance of pixels and could result in unstable V_{f} or electrical leakage development. Such effects could also pose long-term reliability concerns. The efficacy of state-of-the-art pixel Process of Record (POR) designs is currently severely limited by optical performance. One of the main reasons concerns the absorption of the metallic trench.

One could design the trench to stop before coming into contact with the substrate and this would keep the metal contact layer from contacting the substrate and out of the path of the laser lift-off laser as it would get absorbed completely within the GaN epitaxial layer in this case. A problem with this approach is that the GaN thickness that is required to remain at the bottom of the trench is optically thick enough in order to over the tops of the patterns on the sapphire in this example, resulting in poor optical crosstalk between pixels. Another problem is that the remaining epi layer at the bottom of such trench is prone to crack during subsequent processing steps or during field operation. These cracks in the GaN layer at the bottom of the trench can extend into the mesa and active region resulting in performance degradation or pixel failure. Such cracks could also delaminate metal sidewall contacts or insulator layers and therefore create a leakage path or other reliability concerns.

The proposed invention discloses novel die structures and methods of manufacturing that address the above problems.

### SUMMARY

Embodiments of the invention solve the aforementioned issues by providing a light emitting device with a composite contact preventing performance degradation caused during laser lift off, while preventing optical loss during device operation and having good conductivity and current spread. The composite contact may include one or more layers, one of which absorbs the laser to prevent it from reaching the metal trench on the side while being transparent and conductive, a dielectric spacer which prevents optical loss, and a thin contact layer providing better contact with the metal trench.

### BRIEF DESCRIPTION OF THE DRAWINGS

Figure 1 shows a cross-section of a light emitting device with a composite contact having a transparent conductive layer extending below the bottom of the epitaxial layer, according to embodiments of the invention.
Figure 2 shows a cross-section of a light emitting device with a composite contact having a transparent conductive layer that does not extend below the bottom of the epitaxial layer, according to embodiments of the invention.
Figure 3 shows a cross-section of a light emitting device with a composite contact and without a wavelength converting layer, according to embodiments of the invention.
Figure 4 shows a flow chart of a process for obtaining a light emitting device according to embodiments of the invention.

### DETAILED DESCRIPTION

The following detailed description should be read with reference to the drawings, in which identical reference numbers refer to like elements throughout the different figures. The drawings, which are not necessarily to scale, depict selective embodiments and are not intended to limit the scope of the invention. The detailed description illustrates by way of example, not by way of limitation, the principles of the invention. This description will clearly enable one skilled in the art to make and use the invention, and describes several embodiments, adaptations, variations, alternatives and uses of the invention.

As used in this specification and the appended claims, the singular forms "a," "an," and "the" include plural referents unless the context clearly indicates otherwise. Also, the term "parallel" is intended to mean "substantially parallel" and to encompass minor deviations from parallel geometries. The term "vertical" refers to a direction parallel to the force of the earth's gravity. The term "horizontal" refers to a direction perpendicular to "vertical." The term "on" means to be disposed to overlap (e.g., vertically) and/or to be directly in contact with.

To resolve some of the problems stated in the Background section above, an optically transparent and electrically conductive composite layer is incorporated and includes of at least one TCO (transparent conductive oxide) layer with a bandgap close to that of the epitaxial layer at the bottom of the epitaxial layer (GaN in this example). Such a protective TCO layer will protect the metallic trenches and prohibit or inhibit the laser's interaction with those metallic trenches (the laser lift-off laser power may be all or mostly absorbed within this TCO layer before reaching metallic layers). Materials suitable for such a layer for GaN-based LEDs include one or more of ZnO and ITO. ZnO has a high optical transmittance at visible wavelengths with a bandgap of 3.37 eV, which is close to that of GaN (3.4 eV). Having a bandgap close to GaN (e.g., within plus or minus 1.0 eV, such as within plus or minus 0.5 eV) means that ZnO will absorb the laser beam in a similar manner to GaN and therefore can be separated from the substrate during the same laser lift-off step used to separate the GaN and it will protect metallic layers from the LLO laser beam. The thickness of the TCO layer could be in the range of tens of nanometer to few hundred nanometers (e.g. from 10 nm - 1000 nm), thick enough to ensure that the laser beam is fully absorbed by the bottom section of this layer and does not reach the metallic trenches. Laser lift-off of ZnO films has been successfully achieved in practice.

Besides the TCO layer, the integrated composite layer may include a thick enough dielectric layer. The dielectric layer further reduces light interaction with the metal trench, thereby reducing light absorption by the metal trench. In combination with the TCO layer, this approach allows for a thin, conformal coating of a laser lift-off separable layer covering the sapphire at the bottom of the trench, which protects the metallic layers while still providing good optical contrast between pixels.

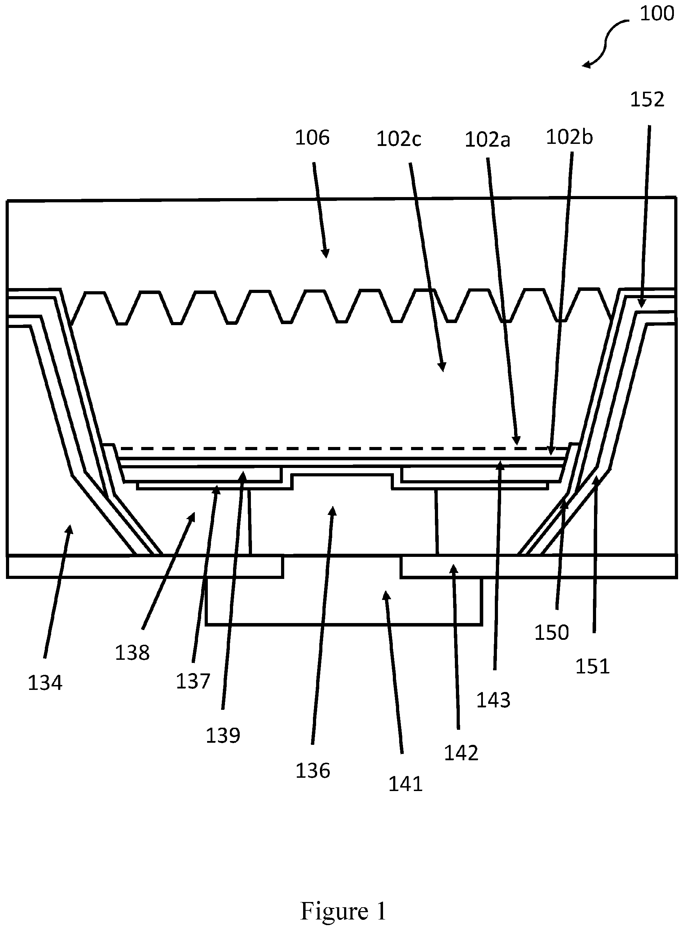

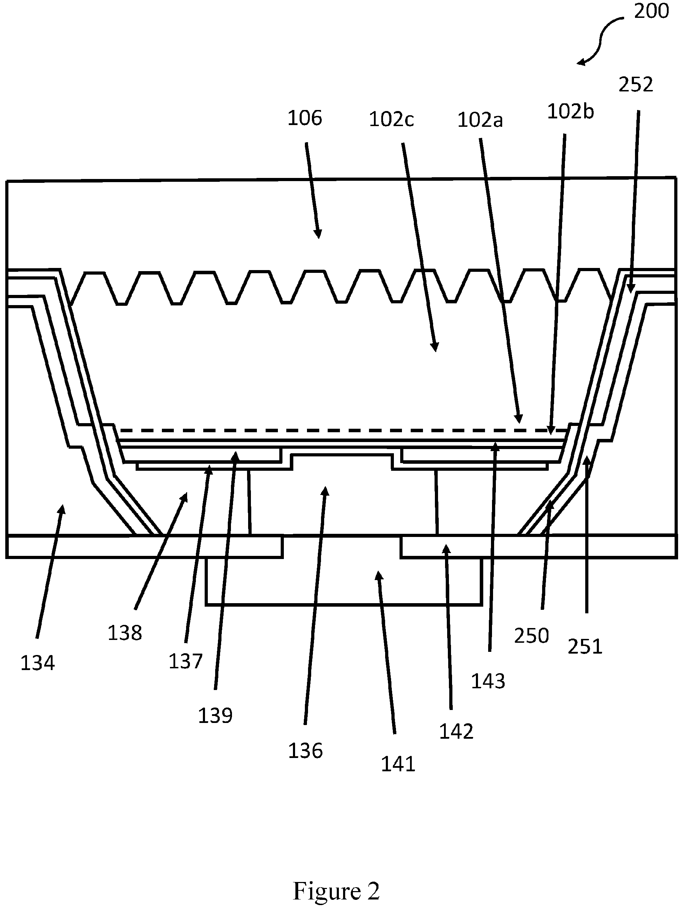

Compared to conventional devices, optical simulations suggest lm/W gains can improve by more than 10% by partially optically isolating the trench in ways presented in Fig. 1-3. Unlike POR, embodiments of the invention involves contact formation at the mesa bottom over a limited region around the periphery of said pixel. This allows optically isolating the trenches with dielectric material (including DBR). Fig. 1 and 2 include a thin layer that reinforces a proper electrical contact between the trench metallization and the TCO (e.g. ITO-Cr-Al). As seen in Fig. 1 and 2, electrical contact between n-metal trench and TCO is located preferentially under the p-metal contact. This reduces direct light interaction with trench metal as the rest of the trench metal surface is coated with a sufficiently thick dielectric layer acting as a light blocking layer separating the epitaxial layers from the cathode metallization. The TCO layer thus functions as a spreading layer for carriers to be transported from the trench metallization to the n-contact regions. Such composite n-contact structure offers a significant optical loss reduction with a sufficiently transparent TCO layer can be manufactured, which may include limiting the TCO thickness and/or limiting overall spreading conductivity. Figure 2 is an embodiment that reduces the requirements in TCO spreading conductivity to a bare minimum since it may be the thin Cr layer that is the dominant spreading layer to transport carriers to the n-contact region.

Figure 1 illustrates a cross section of an LED 100 according to embodiments of the invention (in the figures illustrated in this application, the elements may be symmetric about an imaginary vertical line through a center of the figure, and so for clarity are not double labeled). The LED 100 includes a n-doped semiconductor layer 102c, a p-doped semiconductor layer 102b, and an active region 102a between them. The semiconductor layer can include one or more III-nitride materials or other suitable semiconductor materials, and may include one or more of InGaN and/or AlInGaP. The active region 102a can include one or more of the same or similar materials, and may emit light at a first wavelength or wavelength range. The LED 100 may include a wavelength converting layer 106, excited by the light of the active region 102a to emit light of a second wavelength different from the first wavelength. The wavelength converting layer 106 may have a patterned surface interfaced with a patterned surface of the n-doped semiconductor layer 102c. The patterning of this light emitting surface may increase light extraction from the LED 100. Alternatively, the interface between wavelength converting layer 106 and n-doped semiconductor 102c may be entirely flat or planar.

One or more metal trenches 134 are electrically conductive and in electrical contact with the n-doped layer 102c. One or more p-contacts 136 are electrically conductive and in electrical contact with the p-doped layer 102b. The metal trenches 134 and the p-contacts 136 may be or include one or more metals (e.g., Al, Cu, Ag, Au). A metallic layer 137 may be disposed between the p-contact 136 and the p-doped layer 102b. The metallic layer 137 may itself include multiple layers, for example of different metals from each other (e.g. Ag and Pt). Between the p-doped layer 102b and the metallic layer 137 there may be a TCO layer 143 in direct contact with both, which may operate as a current spreading transparent layer.

The LED 100 may include a dielectric layer 138 on the p-doped layer 102b. The p-contact 136 may extend through the dielectric layer 138 to make contact with the p-doped layer 102b. The dielectric layer 138 may be or include one or more of, for example, silica, oxides, nitrides, and oxynitrides. There may also be a bonding layer 141 that is electrically conductive and in electrical contact with the p-contact 136, disposed on a spacer layer 142 that is insulating.

The LED 100 includes a composite n-contact that includes a transparent conductive layer 150, a thin conductive layer 151, and a contact dielectric spacer 152. The transparent conductive layer 150 and the thin conductive layer 151 may be electrically conductive and may each be in electrical contact and/or direct physical contact. The transparent conductive layer 150 and the thin conductive layer 151 may be in electrical contact the metal trench 134, and at least one them may be in direct physical contact with the metal trench 134. The transparent conductive layer 150 may be a TCO layer such as ZnO or ITO. The thin conductive layer 151 may be any suitable metal, such as chromium or titanium. The thin conductive layer 151 may be less transparent than the transparent conductive layer 150, though this is not a requirement and they may have a same or similar transparency. The contact dielectric spacer 152 may be a composite material stack forming a distributed bragg reflector (DBR). The contact dielectric spacer 152 may have a higher reflectivity than the metal trench 134. The contact dielectric spacer 152 may extend below the top of the dielectric spacer 138, and below the bottom surface of the p-doped layer 102b.

According to embodiments of the invention, Figure 2 illustrates a cross section of an LED 200 with some of the same elements as described in Figure 1, and some different elements. Figure 2 includes a transparent conductive layer 250, a thin conductive layer 251, and a contact dielectric spacer 252 or similar or same materials as those described in relation to Figure 1, except that the shape of them may be different. For example, the direct contact area of thin conductive layer 251 with transparent conductive layer 250 may be greater than that between thin conductive layer 151 and transparent conductive layer 150. The thin conductive layer 251 may conform to and be in direct contact with the transparent conductive layer 250 from the top to the bottom of dielectric layer 138, in contrast to the thin conductive layer 151 and transparent conductive layer 150, which may only be in direct contact with each other along a partial height of the dielectric layer 138. The vertical height of the contact area of thin conductive layer 251 with transparent conductive layer 250 may also be greater than the vertical height of respective areas of the thin conductive layer 251 and the transparent conductive layer 250 are not in direct physical contact with each other, e.g. greater than those areas that are in direct contact with contact dielectric spacer 252 instead. Furthermore, the bottommost portion of contact dielectric spacer 252 may be disposed flush with or above the top of dielectric layer 138, above or flush with the active region 102a, above p-doped semiconductor layer 102b, and so on as shown in Fig. 2. The increased contact area between thin conductive layer 251 and transparent conductive layer 250 reduces the requirements of the transparent conductive layer 250 in spreading current, making the thin conductive layer 251 the dominant spreading layer to transport carriers to the n-contact region.

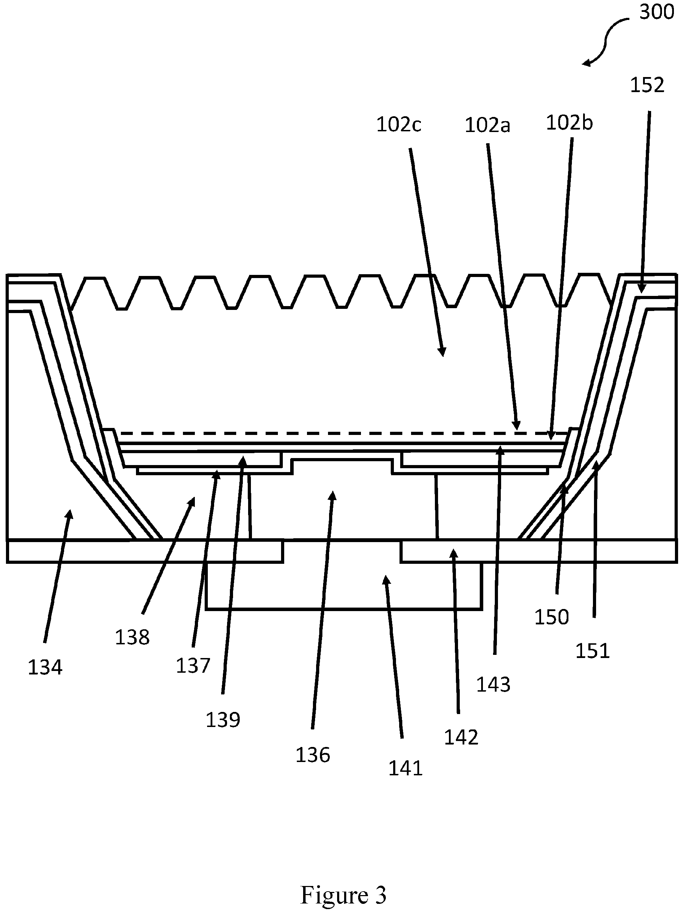

According to embodiments of the invention, Figure 3 illustrates a cross section of an LED 300 with some of the same elements as described in Figure 1, except without a wavelength converting layer 106. LED 300 may be used in a direct emitting LED such that the light emitted by the active region 102a is designed to be emitted from LED 300 without any phosphor in its light path. LEDs 300 may be arranged on a common backplane with adjacent LEDs 300 emitting different colors from each other from their respective active regions 102a, such as red, green, or blue.

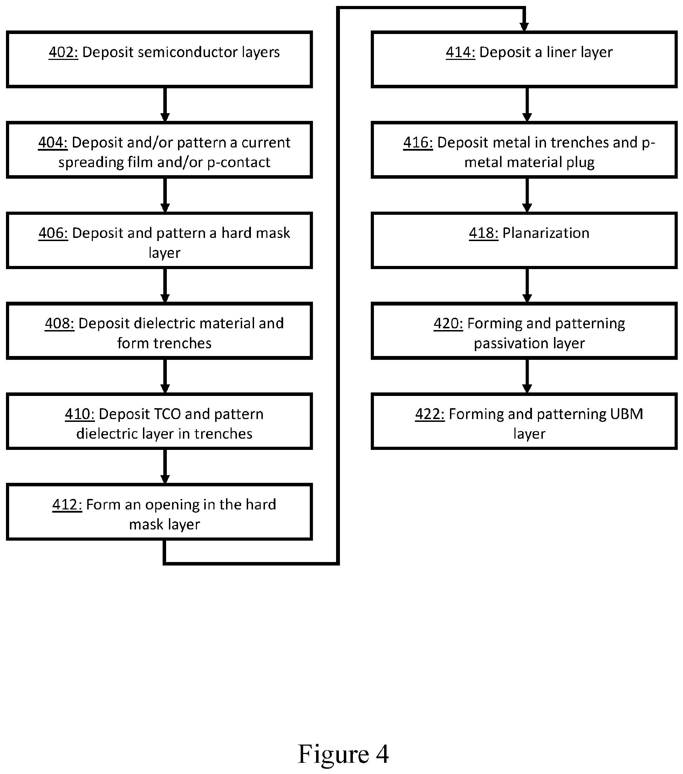

Fig. 4 illustrates an example process for forming one or more of the semiconductor structures above. At 402, the semiconductor layers p-doped semiconductor layer 102b, n-doped semiconductor layer 102c, and active region 102a may be grown on sapphire or other suitable growth substrate, such as silicone, quartz, ZnO, MgO, and so on. The growth substrate may be transparent. At 404, a current spreading film such and/or p-contact 136 may be deposited and patterned on the semiconductor structure. At 406, deposit and pattern a hard mask layer. At 408, deposit dielectric material (e.g. dielectric layer 138) and form trenches (e.g. space where metal trenches 134 will be deposited). At 410, deposit TCO layer (such as TCO layer 143) and pattern dielectric layer 134 in trenches. At 412, form an opening in the hard mask layer. At 414, deposit a liner layer. At 416, deposit metal in trenches and p-metal material plug, such as p-contact 136. At 418, conduct planarization. At 420, form and pattern a passivation layer, such as spacer layer 142. At 422, form and pattern a UBM layer, such as bonding layer 141.

The disclosures provided in this specification are intended to illustrate but not necessarily to limit the described implementation. As used herein, the term "implementation" means an implementation that serves to illustrate by way of embodiments but not limitation. The techniques described in the preceding text and figures can be mixed and matched as circumstances demand to produce alternative implementations. It will be apparent to those of ordinary skill in the art that numerous variations, changes, and substitutions of the embodiments described above can be made without departing from the invention. Furthermore, it shall be understood that all aspects of the invention are not limited to the specific depictions, configurations or relative proportions set forth herein which depend upon a variety of conditions and variables. It should be understood that various alternatives to the embodiments of the invention described herein may be employed in practicing the invention. It is therefore contemplated that the invention shall also cover any such alternatives, modifications, variations or equivalents. All such alternatives will be apparent to one skilled in the art in light of this disclosure and are intended to fall within the scope of the appended claims.

### FURTHER ASPECTS

Aspect 1. A light emitting device comprising:
a semiconductor structure comprising an n-doped semiconductor layer, a p-doped semiconductor layer, and an active region between the n-doped semiconductor layer and the p-doped semiconductor layer, the semiconductor structure comprising a top surface, a bottom surface, and side walls connecting the top surface with the bottom surface;
a p-contact in electrical contact with the p-doped semiconductor layer;
a transparent conductive layer disposed on at least one of the side walls of the semiconductor structure;
a thin contact layer in electrical contact with the transparent conductive layer; and
a dielectric spacer disposed between part of the transparent conductive layer and part of the thin contact layer.

Aspect 2. The light emitting device of aspect 1, further comprising a metal trench in electrical contact with the thin contact layer and the transparent conductive layer.

Aspect 3. The light emitting device of aspect 2, wherein the thin contact layer is in direct contact with the metal trench.

Aspect 4. The light emitting device of aspect 2, wherein the dielectric spacer has a higher reflectivity than the metal trench.

Aspect 5. The light emitting device of aspect 2, wherein the metal trench is not in direct contact with the transparent conductive layer nor the dielectric spacer.

Aspect 6. The light emitting device of aspect 1, wherein the thin contact layer has a first region and a second region and is in direct contact with the transparent conductive layer at the first region and in direct contact with the dielectric spacer at the second region.

Aspect 7. The light emitting device of aspect 6, wherein the first region has a greater height in a vertical direction compared to the second region, the vertical direction being perpendicular to a horizontal direction along which the bottom surface of the semiconductor structure extends.

Aspect 8. The light emitting device of aspect 7, wherein the transparent conductive layer has a third region and a fourth region and is in direct contact with thin contact layer at the third region and in direct contact with the dielectric spacer at the fourth region, the third region having a greater height in the vertical direction than the fourth region.

Aspect 9. The light emitting device of aspect **1,** wherein the thin contact layer comprises metal.

Aspect 10. The light emitting device of aspect 9, wherein the thin contact layer comprises chromium.

Aspect 11. The light emitting device of aspect 9, wherein the thin contact layer comprises titanium.

Aspect 12. The light emitting device of aspect **1,** wherein the transparent conductive layer comprises oxide.

Aspect 13. The light emitting device of aspect **1,** wherein the transparent conductive layer comprises ZnO or ITO.

Aspect 14. The light emitting device of aspect **1,** wherein the transparent conductive layer has a thickness from 10 nm - 1000 nm.

Aspect 15. The light emitting device of aspect 1, wherein the dielectric spacer comprises multiple layers.

Aspect 16. The light emitting device of aspect 1, wherein the dielectric spacer is not in direct contact with the semiconductor structure.

Aspect 17. The light emitting device of aspect 1, wherein the dielectric spacer comprises DBR.

Aspect 18. The light emitting device of aspect 1, further comprising a wavelength converting layer disposed on the top surface of the semiconductor structure.

Aspect 19. The light emitting device of aspect 1, wherein the top surface of semiconductor structure is patterned.

Aspect 20. A method of manufacturing a light emitting diode (LED) device comprising:
forming a semiconductor structure on a substrate, the semiconductor structure comprising an n-type layer, a p-type layer, and an active layer between the n-type layer and the p-type layer, the semiconductor structure comprising a top surface, a bottom surface, and side walls connecting the top surface and the bottom surface;
depositing a transparent conductive layer on at least one of the side walls;
depositing a dielectric layer on the transparent conductive layer;
depositing a thin contact layer on the transparent conductive layer and the dielectric layer, the thin contact layer in electrical contact with the transparent conductive layer;
depositing a metal trench in electrical contact with the thin contact layer and the transparent conductive layer; and
forming a p-type contact on the bottom surface of the semiconductor structure.

## Claims

1. A light emitting device comprising:
a semiconductor structure comprising an n-doped semiconductor layer, a p-doped semiconductor layer, and an active region between the n-doped semiconductor layer and the p-doped semiconductor layer, the semiconductor structure comprising a top surface, a bottom surface, and side walls connecting the top surface with the bottom surface;
a p-contact in electrical contact with the p-doped semiconductor layer;
a transparent conductive layer disposed on at least one of the side walls of the semiconductor structure;
a thin contact layer in electrical contact with the transparent conductive layer; and
a dielectric spacer disposed between part of the transparent conductive layer and part of the thin contact layer.

2. The light emitting device of claim 1, further comprising a metal trench in electrical contact with the thin contact layer and the transparent conductive layer.

3. The light emitting device of claim 2, wherein the thin contact layer is in direct contact with the metal trench.

4. The light emitting device of claim 2, wherein the dielectric spacer has a higher reflectivity than the metal trench.

5. The light emitting device of claim 2, wherein the metal trench is not in direct contact with the transparent conductive layer nor the dielectric spacer.

6. The light emitting device of claim 1, wherein the thin contact layer has a first region and a second region and is in direct contact with the transparent conductive layer at the first region and in direct contact with the dielectric spacer at the second region.

7. The light emitting device of claim 6, wherein the first region has a greater height in a vertical direction compared to the second region, the vertical direction being perpendicular to a horizontal direction along which the bottom surface of the semiconductor structure extends.

8. The light emitting device of claim 7, wherein the transparent conductive layer has a third region and a fourth region and is in direct contact with thin contact layer at the third region and in direct contact with the dielectric spacer at the fourth region, the third region having a greater height in the vertical direction than the fourth region.

9. The light emitting device of claim 1, wherein the thin contact layer comprises metal.

10. The light emitting device of claim 9, wherein the thin contact layer comprises chromium.

11. The light emitting device of claim 9, wherein the thin contact layer comprises titanium.

12. The light emitting device of claim 1, wherein the transparent conductive layer comprises oxide.

13. The light emitting device of claim 1, wherein the transparent conductive layer comprises ZnO or ITO.

14. The light emitting device of claim 1, wherein the transparent conductive layer has a thickness from 10 nm - 1000 nm.

15. A method of manufacturing a light emitting diode (LED) device comprising:
forming a semiconductor structure on a substrate, the semiconductor structure comprising an n-type layer, a p-type layer, and an active layer between the n-type layer and the p-type layer, the semiconductor structure comprising a top surface, a bottom surface, and side walls connecting the top surface and the bottom surface;
depositing a transparent conductive layer on at least one of the side walls;
depositing a dielectric layer on the transparent conductive layer;
depositing a thin contact layer on the transparent conductive layer and the dielectric layer, the thin contact layer in electrical contact with the transparent conductive layer;
depositing a metal trench in electrical contact with the thin contact layer and the transparent conductive layer; and
forming a p-type contact on the bottom surface of the semiconductor structure.
